# EUROPÄISCHE PATENTANMELDUNG

(11) **EP 3 758 230 A1**
(43) Veröffentlichungstag der Anmeldung: **30.12.2020**
(21) Anmeldenummer: 20176984.1
(22) Anmeldetag: 28.05.2020
(51) Int. Cl.: H03K 17/955

(54) **SENSOREINRICHTUNG MIT KAPAZITIVEM SENSOR**

(30) Priorität: 28.06.2019 DE 102019209430
(71) Anmelder: Robert Bosch GmbH, 70442 Stuttgart (DE)
(72) Erfinder: Bonemberg, Adam, 70195 Stuttgart (DE); Becker, Ralf, 71672 Marbach (DE); Fischer, Chris, 70435 Stuttgart (DE); Iske, Burkhard, 71272 Renningen (DE)

(57) **Zusammenfassung**

Sensoreinrichtung (1) mit einer ersten Elektrode (2), mit einer Signalerzeugungseinrichtung (22), welche diese erste Elektrode (2) mit einem elektrischen Signal (S) beaufschlagt, wodurch die erste Elektrode (2) ein elektrisches Feld (E1) ausgibt, mit einer zweiten Elektrode (4), welche von der ersten Elektrode (2) beabstandet ist, zur Aufnahme des von der ersten Elektrode ausgegebenen elektrischen Feldes, zu dem ein Messwert M1 gehört.

Erfindungsgemäß weist die Sensoreinrichtung (1) eine dritte Elektrode (6) auf, sowie eine Signalerzeugungseinrichtung (62), welche diese weitere Elektrode (6) mit einem zweiten elektrischen Signal (S2) beaufschlagt, wodurch die weitere Elektrode (6) ein weiteres elektrisches Feld (E2) ausgibt, zu dem ein Messwert M2 gehört.

## Beschreibung

Die vorliegende Erfindung bezieht sich auf eine Sensoreinrichtung und insbesondere eine Sensoreinrichtung, welche einen kapazitiven Sensor aufweist. Kapazitive Sensoren werden auf vielfältige Art zur Erkennung von dielektrischen und leitfähigen Objekten im Nahbereich eines elektrischen Feldes genutzt. Insbesondere zur Erkennung von Personen und Lebewesen eignet sich das kapazitive Wirkprinzip gut. Die Objekterkennung kann zur Realisierung von Komfortfunktionen, wie zum Beispiel bei berührungsempfindlichen Bildschirmen oder auch zur Realisierung von Sicherheitsfunktionen, wie zum Beispiel für die Mensch-Roboter-Kollaboration, eingesetzt werden.

Weitere Anwendungen sind beispielsweise Füllstandsensoren und Näherungsschalter, die in einer Prozesssteuerung Anwendung finden können.

Eine kapazitive Sensorik ermöglicht berührungslose Sicherheitsfunktionen, die einen sicheren Zustand einleiten, noch bevor es zu einer Krafteinwirkung auf Objekte im Gefahrenbereich kommt. Hierfür müssen die Sensoren eine hinreichend große Detektionsreichweite aufweisen, um Reaktions- und Verzögerungszeiten Rechnung tragen zu können.

Um Objekte sicher zu detektieren, eignen sich kapazitive Sensoriken, die nach dem Prinzip der projizierten wechselseitigen Kapazität (mutual capacitance) arbeiten und aus Elektrodenpaaren bestehen, bei denen in der Regel eine Elektrode ein veränderliches elektrisches Feld aufspannt bzw. ausgibt, und mittels einer zweiten Elektrode innerhalb des Feldes, der induzierte Verschiebungsstrom gemessen wird. Dabei erfasst diese Art der kapazitiven Sensorik auch Umgebungseinflüsse, wie etwa Luftfeuchtigkeit, Spritzwasser im Nahbereich des Sensors.

Daneben können sich auch temperaturbedingte Ausdehnung und Kompression, insbesondere der mechanischen Teile im Nahbereich des Sensors und auch die Temperaturabhängigkeit in der Charakteristik der verwendeten Schaltungsbauteile auswirken. Für eine robuste Näherungserkennung müssten diese Einflüsse entweder durch Beschränkung der Anwendungen, oder aber durch zusätzliche Einrichtungen vermieden oder aber durch geeignete Maßnahmen kompensiert werden.

Insbesondere im Außenbereich und/oder bei rasch wechselnden Umgebungsbedingungen, zum Beispiel beim Einsatz in Kraftfahrzeugen, sind aus diesem Grund kapazitive Sensoren kaum verbreitet.

Aus der DE 10 2016 217 545 A1 ist es bekannt, Elektrodenanordnungen und Mittel zum Unterbrechen eines Wasserfilms vor einem kapazitiven Sensor zu verwenden, wobei die Sensorfunktion auch bei Bildung eines Wasserfilms vor dem Sensor, zum Beispiel im Außenbereich erhalten bleibt.

Aus der US 939 0061 B ist ein Zwei-Sensor-System bekannt, bei dem ein beweglicher Sensor die Objekterkennung übernimmt und ein unbeweglicher Sensor zur Erkennung von Umwelteinflüssen eingesetzt wird. Der vorliegenden Erfindung liegt die Aufgabe zugrunde, eine Erkennung und Kompensation von Umwelteinflüssen auf eine Näherungserkennung zu ermöglichen. Dabei soll ein rein kapazitiv wirkender Sensor eingesetzt werden, der besonders bevorzugt nach dem Mutual-Capacitance-Prinzip arbeitet.

Diese Aufgabe wird erfindungsgemäß durch eine Vorrichtung und ein Verfahren gemäß den unabhängigen Ansprüchen erreicht. Vorteilhafte Ausführungsformen und Weiterbildungen sind Gegenstand der Unteransprüche.

Eine erfindungsgemäße Sensoreinrichtung, insbesondere eine kapazitive Sensoreinrichtung weist eine erste Elektrode auf, sowie eine Signalerzeugungseinrichtung, welche diese erste Elektrode mit einem elektrischen Signal beaufschlagt, wodurch die erste Elektrode ein elektrisches Feld ausgibt. Weiterhin weist die Sensoreinrichtung eine zweite Elektrode auf, welche von der ersten Elektrode beabstandet ist und welche zur Aufnahme des von der ersten Elektrode ausgegebenen elektrischen Feldes geeignet und bestimmt ist.

Erfindungsgemäß weist die Sensoreinrichtung eine dritte Elektrode auf, sowie eine Signalerzeugungseinrichtung, welche diese dritte Elektrode mit einem zweiten elektrischen Signal beaufschlagt, wodurch die dritte Elektrode ein weiteres elektrisches Feld ausgibt.

Zu dem genannten elektrischen Feld, welches von der ersten Elektrode ausgegeben wird, kann ein erster Messwert (unten als M1 bezeichnet) korrespondieren bzw. gehören. Zu dem genannten elektrischen Feld, welches von der dritten Elektrode ausgegeben wird, kann ein zweiter Messwert (unten als M2 bezeichnet) korrespondieren bzw. gehören.

Es wird daher vorgeschlagen, dass zusätzlich zu den herkömmlich verwendeten beiden Elektroden noch eine weitere Elektrode verwendet wird, die im Folgenden beschrieben wird und die insbesondere zur Erkennung von Elementen oder Störungen im Nahfeldbereich dient. Bevorzugt wird also eine Sensoreinrichtung um eine oder zwei oder mehrere zusätzliche Elektroden, im Folgenden auch als Kompensationselektroden bezeichnet, erweitert, die besonders bevorzugt nahe zu den bestehenden Elektroden angeordnet werden und die besonders bevorzugt eine dezidierte Erfassung von Veränderungen im Nahbereich des Sensors bzw. dessen Elektroden sowie bevorzugt auch Änderungen in der Charakteristik der Mess- und Oszillatorschaltung ermöglichen. Dies ist dabei bevorzugt unabhängig von Objekteinflüssen im Fernbereich.

Bei einer bevorzugten Ausführungsform sind die erste Elektrode und die zweite Elektrode in einer gemeinsamen Ebene angeordnet. Bei einer weiteren bevorzugten Ausführungsform sind die erste und die zweite Elektrode versetzt zueinander in einer Richtung angeordnet, welche in der Ebene wenigstens einer der beiden Elektroden verläuft. Bevorzugt sind also die beiden Elektroden nicht gegenüber einander angeordnet (wie dies etwa bei einem Kondensator der Fall wäre.

Der erfindungsgemäße Sensor ist daher in der Lage, den Einfluss durch Objekte, beispielsweise durch tropfenförmig vorliegendes oder in Rinnen abfließendes Tropf-, Sprüh- oder Regenwasser zu kompensieren, insbesondere, solange zwischen den beiden erstgenannten Elektroden kein geschlossener Wasserfilm vorliegt.

Bei einer ersten bevorzugten Ausführungsform ist die erste Elektrode eine Sendeelektrode, die das genannte elektrische Feld ausgibt. Bei dem elektrischen Feld handelt es sich bevorzugt um ein elektrostatisches Wechselfeld. Bevorzugt ist die zweite Elektrode eine Messelektrode, welche das von der Sensorelektrode ausgegebene, insbesondere elektrische Feld erfasst und/oder misst.

Bevorzugt handelt es sich bei der dritten Elektrode um eine weitere Sendeelektrode, die ebenfalls ein elektrisches Feld ausgibt. Dieses elektrische Feld, kann dabei insbesondere von der zweiten Elektrode erfasst werden.

Bei einer weiteren bevorzugten Ausführungsform weist die Sensoreinrichtung eine Verstärkereinrichtung und insbesondere einen Signalverstärker auf, welche einen Verschiebestrom auf der zweiten Elektrode bzw. der Messelektrode möglichst unverfälscht in ein Messsignal, und insbesondere in ein auswert- und übertragbares Messsignal überführt.

Bei einer weiteren bevorzugten Ausführungsform weist die Sensoreinrichtung eine Auswerteeinrichtung auf, die das Messsignal verarbeitet. Dabei ist diese Auswerteeinrichtung bevorzugt auch in der Lage Messwerte zurückzugeben, um gegebenenfalls eine Näherungserkennung zu signalisieren.

Bei einer weiteren bevorzugten Ausführungsform weist die Vorrichtung auch eine unten genauer beschriebene Steuereinrichtung auf, die die hier genannten Betriebsarten verwaltet, das heißt die Erfassung von Signalen ausgegeben von der ersten Elektrode und auch die Erfassung von Signalen ausgegeben von der dritten Elektrode.

Bei einer weiteren bevorzugten Ausführungsform ist eine Schaltung, insbesondere eine Oszillatorschaltung vorgesehen, welche ein vorgegebenes Signal, insbesondere ein periodisches Signal ausgibt. Dabei kann dieses Signal beispielsweise rechteckförmig, dreieckförmig, sägezahnförmig oder auch sinusförmig sein. Bevorzugt weist dieses Signal eine hinreichend große Spannungsamplitude auf und es ist auch eine Treiberfähigkeit gegeben.

Bei einer bevorzugten Ausführungsform können Parameter dieses Signals verändert werden, beispielsweise die Signalform, eine Frequenz und/oder eine Amplitude. Dabei ist insbesondere auch eine dynamische Anpassung dieser Parameter möglich.

Bei einer weiteren bevorzugten Ausführungsform ist die Sensoreinrichtung als Näherungssensoreinrichtung ausgebildet und insbesondere dazu geeignet und bestimmt, Objekte in einer Umgebung der Sensoreinrichtung zu erfassen. Unter einer Umgebung der Sensoreinrichtung wird dabei ein Bereich verstanden, dessen Abstand zu den Elektroden geringer ist als 1 m, bevorzugt geringer als 80 cm, bevorzugt geringer als 60 cm und besonders bevorzugt geringer als 50 cm.

Bei einer weiteren bevorzugten Ausführungsform ist die erste und/oder die zweite Elektrode dazu geeignet und bestimmt, das von der dritten Elektrode ausgegebene elektrische Feld aufzunehmen. Besonders bevorzugt ist die zweite Elektrode dazu geeignet und bestimmt, das elektrische Feld aufzunehmen. Damit kann auch in der zweiten Elektrode durch die dritte Elektrode ein Feld verursacht werden bzw. ein Verschiebestrom erzeugt werden. Dieser kann wiederum bestimmt werden.

Bei einer weiteren vorteilhaften Ausführungsform weist die Sensoreinrichtung ein Wasserfilmverhinderungsmittel auf, welches dazu geeignet und bestimmt ist, Wasserfilme, die sich zwischen den beiden Elektrodenfilmen erstrecken, zu verhindern und/oder solche Wasserfilme zu zerstören. Dieses Mittel kann dabei beispielsweise als Vorsprung ausgebildet sein, der zwischen den beiden Elektroden angeordnet ist. Bevorzugt ist dieser Vorsprung aus einem elektrisch nicht leitenden Material ausgebildet. Dieser Vorsprung kann sich dabei beispielsweise senkrecht zu einer geometrischen Verbindungsline, welche von der einen Elektrode zu der anderen Elektrode verläuft, erstrecken.

Bei einer weiteren vorteilhaften Ausführungsform weist die Vorrichtung eine Steuerungseinrichtung auf, welche bewirkt, dass zu ersten vorgegebenen Zeiträumen die erste Elektrode mit dem ersten Signal beaufschlagt wird und zu zweiten vorgegebenen Zeiträumen die dritte Elektrode mit dem zweiten Signal beaufschlagt wird.

Besonders bevorzugt sind diese Zeiträume voneinander getrennt und bevorzugt vollständig voneinander getrennt. Damit wird besonders bevorzugt nicht gleichzeitig das erste und das zweite Signal ausgegeben. Besonders bevorzugt werden die beiden Signale im Wechsel und/oder zyklisch ausgegeben. Dabei ist es möglich, dass das erste Signal im vorgegebenen ersten Zeitraum ausgegeben wird und anschließend das zweite Signal im zweiten Zeitraum. Besonders bevorzugt sind die Zeiträume, in denen das zweite Signal ausgegeben wird, geringer als die Zeiträume, in denen das erste Signal ausgegeben wird.

Auf diese Weise wird dem Umstand Rechnung getragen, dass die Vorrichtung in der Regel als Erfassungseinrichtung dient bzw. als Sensoreinrichtung im normalen Gebrauch und lediglich zeitweise gewissermaßen zu Kalibrierungszwecken mittels der dritten Elektrode für Umwelteinflüsse charakteristische Daten bestimmt werden.

Dabei ist es möglich, dass die elektrischen Signale gleich sind, das heißt sowohl die erste Elektrode als auch die dritte Elektrode mit dem gleichen elektrischen Signal beaufschlagt wird. Es ist jedoch auch möglich, dass sich die Signale, mit denen die erste Elektrode beaufschlagt wird, von denjenigen Signalen, mit denen die dritte Elektrode beaufschlagt wird unterscheiden.

Allgemein erfolgt die Beaufschlagung der Sendeelektrode und der im Folgenden auch als Kombinationselektrode bezeichneten dritten Elektrode mit einem Oszillatorsignal und besonders bevorzugt im Wechsel. Auf diese Weise ergeben sich unabhängige Messwerte M1 und M2 für die beiden Betriebsarten "erste Elektrode angesteuert" (M1) und "dritte Elektrode angesteuert" (M2). Die Oszillatorsignale können dabei für die beiden Betriebsarten verschieden sein.

Bei einer weiteren bevorzugten Ausführungsform spannt in der Betriebsart (erste Elektrode angestellt) die erste Elektrode ein elektrisches Feld auf, das bevorzugt weiter in den Raum ragt und durch Objekte im Fernbereich des Sensors verändert wird. Aber auch Veränderungen und Objekte im Nahbereich des Sensors, zum Beispiel Wassertropfen, abfließendes Wasser oder die temperaturbedingte Ausdehnung von mechanischen Abdeckteilen nehmen messbaren Einfluss auf das Feld, das von dieser ersten Elektrode aufgespannt wird. Derartige Veränderungen wirken daher parasitär. Ebenfalls nehmen Veränderungen in der Charakteristik der Messverstärkerschaltung und der Auswerteeinrichtung Einfluss auf den Messwert mit der angesteuerten ersten Elektrode.

Die besagte dritte Elektrode oder Kompensationselektrode wird bevorzugt so ausgelegt, dass diese in der Betriebsart "Kompensationselektrode angesteuert" ein räumlich konzentriertes Feld im Nahbereich der Messelektrode aufspannt, wie unten dargelegt wird. Der Messwert bei angesteuerter dritter Elektrode wird deshalb vorrangig von Veränderungen im Nahbereich der Messelektrode und Veränderungen in der Charakteristik der Messverstärkerschaltung und der Auswerteeinrichtung beeinflusst.

Somit werden durch Ansteuerung der dritten Elektrode genau diese Einflüsse dezidiert erfasst, die für eine Fernbereichserkennung kompensiert werden müssen.

Bei einer weiteren bevorzugten Ausführungsform ist die dritte Elektrode näher an der zweiten Elektrode als an der ersten Elektrode. So wäre es möglich, dass die dritte Elektrode in die zweite Elektrode integriert ist, beispielsweise elektrisch bzw. galvanisch getrennt in diese eingebaut ist. Auf diese Weise kann die zweite Elektrode Nahfelder der dritten Elektrode erfassen.

Besonders bevorzugt gibt die dritte Elektrode ein elektrisches Feld mit geringerer Reichweite aus als die erste Elektrode. Damit dient besonders bevorzugt die dritte Elektrode zur Erfassung von Objekten in einem Nahbereich, insbesondere der zweiten Elektrode.

Bei einer weiteren bevorzugten Ausführungsform wäre es auch möglich, dass wenigstens eine Elektrode sowohl als Sendeelektrode als auch als Messelektrode wirken kann. So kann durch eine entsprechende Steuerung beispielsweise die erste Elektrode teilweise als Sendeelektrode und teilweise als Messelektrode wirken. Auch ist es möglich, dass die zweite Elektrode zeitweise als Sendeelektrode und zeitweise als Messelektrode wirkt.

Es wäre weiterhin auch denkbar, dass physisch lediglich zwei Elektroden vorhanden sind, jedoch durch eine Steuerung eine Elektrode die Funktionen zweier Elektroden übernimmt. In diesem Falle ist eine Elektrode durch eine entsprechende steuerungsseitige Ansteuerung gegeben. Bevorzugt sind jedoch wie oben erwähnt drei Elektroden physisch vorhanden bzw. drei Elektroden, die besonders bevorzugt elektrisch und/oder galvanisch voneinander getrennt sind.

Bei einer weiteren vorteilhaften Ausführungsform ist eine Elektrodenfläche der dritten Elektrode kleiner als eine Elektrodenfläche der ersten Elektrode und/oder kleiner als eine Elektrodenfläche der zweiten Elektrode.

Bei einer weiteren bevorzugten Ausführungsform ist durch die dritte Elektrode wenigstens teilweise und besonders bevorzugt vollständig von der zweiten Elektrode umgeben. Bevorzugt ist die dritte Elektrode innerhalb einer von der zweiten Elektrode aufgespannten Fläche angeordnet.

Bei einer weiteren bevorzugten Ausführungsform weist die Sensoreinrichtung eine Auswerteeinrichtung auf, welche die von der zweiten Elektrode aufgenommenen und/oder die von der zweiten Elektrode infolge von Induktion ausgegebenen Signale auswertet. Dabei kann es sich wie oben erwähnt insbesondere um induzierte Signale und/oder um einen induzierten Verschiebestrom oder dergleichen handeln.

Bei einer weiteren bevorzugten Ausführungsform weist die Sensoreinrichtung eine vierte Elektrode auf. So könnte die oben beschriebene Sensoreinrichtung eine erste Kompensationselektrode aufweisen sowie auch eine zweite Kompensationselektrode (die vierte Elektrode).

Diese vierte Elektrode könnte dabei nahe an der ersten Elektrode platziert sein. Diese vierte Elektrode bzw. die zweite Kompensationselektrode kann bevorzugt als zweite Messelektrode beschaltet werden und kann einen weiteren Messwert, insbesondere in der Betriebsart Sendeelektrode bzw. erste Elektrode angesteuert aufnehmen.

Besonders bevorzugt wird diese vierte Elektrode bzw. die zweite Kompensationselektrode so gestaltet und angeordnet, dass sich ein Feld zwischen der Sendeelektrode und der Kompensationselektrode räumlich auf den Nahbereich der Sendeelektrode konzentriert.

Die vorliegende Erfindung ist weiterhin auf ein Verfahren zum Betreiben einer kapazitiven Sensoreinrichtung gerichtet, wobei eine Signalerzeugungseinrichtung eine erste Elektrode mit einem elektrischen Strom beaufschlagt und/oder die erste Elektrode mit einem elektrischen Signal versorgt, wodurch die erste Elektrode ein elektrisches Feld ausgibt, wobei mit einer zweiten Elektrode, welche von der ersten Elektrode beabstandet ist, das von der ersten Elektrode ausgegebene elektrische Feld aufgenommen wird.

Erfindungsgemäß weist die Sensoreinrichtung eine dritte Elektrode auf, sowie eine Signalerzeugungseinrichtung, wobei durch diese dritte Elektrode ein weiteres elektrisches Feld ausgeht. Besonders bevorzugt wird das von der dritten Elektrode ausgehende elektrische Feld auch von der zweiten Elektrode erfasst. Bevorzugt wirkt daher auch die dritte Elektrode als Sendeelektrode.

Bei einem bevorzugten Verfahren wird zeitweise die erste Elektrode und zeitweise die dritte Elektrode mit einem elektrischen Signal beaufschlagt. Besonders bevorzugt weichen dabei diese Zeiträume voneinander ab, dass besonders bevorzugt zu keinem Zeitpunkt sowohl die erste als auch die dritte Elektrode mit dem elektrischen Feld bzw. mit dem elektrischen Signal beaufschlagt werden.

Bei einem weiteren bevorzugten Verfahren wird mittels einer Auswerteeinrichtung ein erster Messwert ermittelt, der von dem von der ersten Elektrode ausgegebenen und von der zweiten Elektrode aufgenommenen elektrischen Feld abhängt und es wird weiterhin ein zweiter Messwert ermittelt, der von den von der dritten Elektrode ausgegebenen und von wenigstens einer Elektrode und insbesondere der zweiten Elektrode aufgenommenen Feld abhängt und auf Grundlage des ersten Messwerts sowie des zweiten Messwerts wird ein kompensierter Messwert ermittelt. Dabei kann zur Ermittlung ein mathematisches Verfahren und insbesondere ein Dreisatzverfahren Anwendung finden.

Die Erfindung ermöglicht es damit, eine robuste Annäherungserkennung durch kapazitive Sensorik auch unter wechselnden Umwelteinflüssen dank einer inneren Kompensation zu erreichen. Im Speziellen kann sich die Erfindung beispielsweise für die Umfeldüberwachung beim Anfahren, Rangieren und Parken von Fahrzeugen, insbesondere auch im Innen- und Außenbereich eignen.

Die Erfindung lässt sich bevorzugt zur Realisierung eines robust arbeitenden und sicheren Sensorsystems mit den begleitenden Erfindungen kapazitiver Dreielektrodensensor zur sicheren Fernbereichsdetektion und umgebungsunabhängig lokalisierendes kapazitives Sensorsystem kombinieren, wobei der hier vorgeschlagene Dreielektrodensensor auch zu einem Vier-, Fünf-oder Sechselektrodensensor erweitert werden kann.

Die Erfindung stellt eine hohe Robustheit einer Näherungserkennung unter Umwelteinflüssen, das heißt auch etwa bei Regen, Temperaturschwankungen oder Verformungen von mechanischen Abdeckungen im Bereich eines Sensors zur Verfügung. Auf diese Weise wird ein Funktionsvorteil erreicht.

Weiterhin ist keine dezidierte Sensorik zur Erfassung der Umwelteinflüsse erforderlich und auch kein oder nur ein geringfügiger Platz-Mehrbedarf für Kompensationselektroden in einer bestehenden kapazitiven Sensorik. Auf diese Weise wird ein Integrations- und Kostenvorteil erreicht.

Besonders bevorzugt ist, wie oben erwähnt, die dritte Elektrode bzw. Kompensationselektrode im Vergleich zur Sendeelektrode klein bzw. nimmt eine kleine Fläche ein. Besonders bevorzugt weist diese Kompensationselektrode auch einen geringen Abstand zur Messelektrode auf.

Weiterhin ist es für die Kompensierbarkeit von Wassertropfen, abfließendem Wasser und mechanischen Verhinderungen insbesondere im Nahbereich der Sensoreinrichtungen bei allen Anordnungen vorteilhaft, wenn die Kompensationselektrode in die Richtung des Raumbereichs frei wirken kann, in dem das elektrische Feld zwischen der ersten Elektrode und der zweiten Elektrode besteht.

Bevorzugt führt die oben erwähnte Auswerteeinrichtung mit vorgegebenen Messwerten der unterschiedlichen Betriebsarten, das heißt normale Messung und Messung im Nahbereich mathematisch eine Kompensation durch und liefert einen kompensierten Messwert für eine Fernbereichsdetektion zurück. In einem bevorzugten Verfahren werden mögliche Kompensationsverfahren vorgeschlagen.

Zum einen kann ein Dreisatzverfahren verwendet werden. Dabei ist der Initialwert Mi eines Sensors, der in der Betriebsart mit angesteuerter Kombinationselektrode ohne Objekteinfluss der Referenztemperatur und Referenzfeuchte aufgenommen wird, bekannt. Über eine Dreisatzrechnung ergibt sich ein kompensierter Messwert zu ${M}_{kompensiert} = M 1 * Mi / M 2.$

Bei einem weiteren bevorzugten Verfahren können zweidimensionale Nachschlagetabellen (Englisch: look up table, kurz LUT) Einsatz finden. Dabei wird zunächst die Sensoreinrichtung kalibriert. Dazu kann in einem ersten Kalibrationsschritt ein Referenzobjekt im Fernbereich der Sensoreinrichtung an verschiedenen definierten Positionen (insbesondere bei Referenztemperatur und Referenzfeuchtigkeit platziert werden.

Bevorzugt werden dann in einer Tabelle, insbesondere einer wenigstens zweidimensionalen Tabelle entlang der beiden Dimensionen die Messwerte M1 und M2 aus der Kalibration aufgetragen. Die Zellinhalte, die den kompensierten Messwerten Mₖₒₘₚₑₙₛᵢₑᵣₜ entsprechen, werden jeweils mit dem Referenzmesswert M1 aus der Kalibration gefüllt.

In einem weiteren Kalibrationsschritt wird ebenfalls ein Referenzobjekt im Fernbereich des Sensors an verschiedenen definierten Positionen platziert.

Zusätzlich wird die Sensoreinrichtung dann den zu kompensierenden Einflüssen ausgesetzt, wie beispielsweise Spritzwasser, Änderung von Temperatur und Luftfeuchtigkeit oder mechanischen Veränderungen im Nahbereich des Sensors. Die Wertetabelle wird weiter befüllt, wobei in den Zellen zu jedem Messwertepaar (M1/M2) nun nicht der aktuelle Messwert M1 notiert wird, sondern der Referenzwert passend zur Position des Objekts aus dem ersten Kalibrationsschritt. Bevorzugt wird die während der Kalibration generierte Wertetabelle als LUT gespeichert und insbesondere in der oben erwähnten Auswerteeinrichtung gespeichert.

Bei der eigentlichen Fernbereichsdetektion wird der Tabellenteil an der Stelle der aktualisierten oder aktuellen Messwerte M1 und M2 nachgeschlagen und/oder -bevorzugt durch Interpolation von Referenzwerten aus benachbarten Feldern interpoliert und als der kompensierte Messwert Mₖₒₘₚₑₙₛᵢₑᵣₜ zurückgegeben.

Bei einem weiteren möglichen Verfahren wird eine Modellfunktion angewandt. Dabei kann die Nachschlagtabelle (siehe oben) mit einer mathematischen Funktion abgebildet werden. Zusätzlich bzw. optional wäre es auch möglich, einige Stützpunkte aus einer Kalibration zur Hilfe zu nehmen, insbesondere um Modellparameter festzulegen.

Durch ein Einsetzen von aktuellen Messwerten in die Modellfunktion kann ein kompensierter Messwert ermittelt werden. Hierfür gilt Mₖₒₘₚₑₙₛᵢₑᵣₜ = f(Ml, M2).

Das oben beschriebene Dreisatzverfahren hat von den drei genannten Verfahren den Vorteil von geringsten Anforderungen an Speicher und Rechenleistung, liefert aber auch die am wenigstens robusten bzw. genauen Ergebnisse. Das beschriebene Verfahren mit der Nachschlagetabelle liefert bei entsprechender Qualität der Kalibrationsdaten sehr gute Ergebnisse, geht aber mit einem erhöhten Speicherbedarf einher. Das Verfahren mit der oben beschriebenen Modellfunktion erlaubt einen systemspezifischen Kompromiss aus Robustheit, Speicherbedarf und Rechenaufwand.

Es wäre weiterhin auch denkbar, ein künstliches neuronales Netz als Modellfunktion und/oder zum Erstellen einer Modellfunktion zu verwenden. Dabei könnte eine Anpassung oder ein Training durch ein insbesondere maschinelles Lernen erfolgen.

Dabei könnten als Eingabewerte die jeweils gemessenen Messwerte (unten als M1 und M2 bezeichnet) verwendet werden und auch Trainingsdaten, bei denen es sich etwa um die Referenzwerte aus der Kalibration bei verschiedenen Umgebungsbedingungen und/oder der zugehörigen Position eines Referenzobjekts handeln kann. Als Ausgabewert könnte wiederum ein kompensiertes Messwert Mₖₒₘₚₑₙₛᵢₑᵣₜ ausgegeben werden.

Zusätzlich wäre auch ein Dynamisches Training im Betrieb und/oder zur Laufzeit denkbar. Bevorzugt wird die Sensoreinrichtung mit einem oder mehreren mathematischen Verfahren betrieben, die den Messwerten M1 und M2 einen kompensierter Messwert Mₖₒₘₚₑₙₛᵢₑᵣₜ zuordnet. Dabei ist es möglich, diesen kompensierten Messwert und/oder die Messwerte M1 und M2 durch Kalibration oder Training einzustellen.

Weitere Vorteile und Ausführungsformen ergeben sich aus den beigefügten Zeichnungen.

Darin zeigen:
- Fig. 1: eine Sensoreinrichtung nach dem Stand der Technik;
- Fig. 2: eine schematische Darstellung einer erfindungsgemäßen Sensoreinrichtung;
- Fig. 3: die Sensoreinrichtung aus Figur 2 in einem Kalibrierzustand;
- Fig. 4: die Darstellung einer Nachschlagetabelle;
- Fig. 5: die Darstellung einer Funktion zur Auswertung von Messergebnissen;
- Fig. 6: eine schematische Darstellung einer weiteren erfindungsgemäßen Ausführungsform;
- Fig. 7: eine weitere schematische Darstellung einer erfindungsgemäßen Ausführungsform;
- Fig. 8: eine weitere schematische Darstellung einer erfindungsgemäßen Ausführungsform einer Sensoreinrichtung.

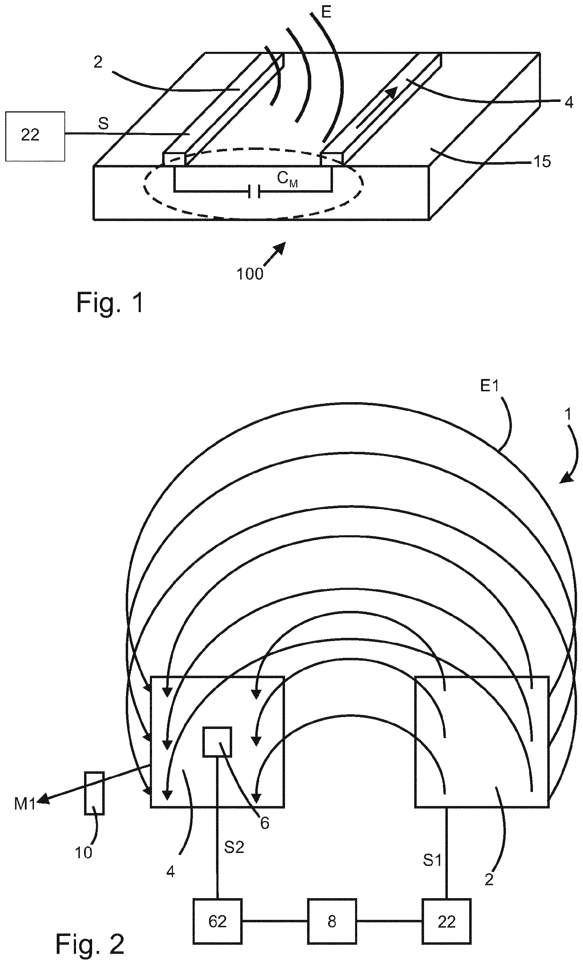

Figur 1 zeigt eine schematische Darstellung einer Sensoreinrichtung 100 nach dem Stand der Technik. Diese Sensoreinrichtung 100 weist eine erste Elektrode 2 auf sowie eine zweite Elektrode 4. Diese Elektroden sind an einem gemeinsamen Träger 15 angeordnet. Das Bezugszeichen 22 kennzeichnet eine Signalerzeugungseinrichtung, welche an die erste Elektrode 2 ein Signal S ausgibt. Dieses Signal erzeugt ein elektrisches Feld E. Dieses elektrische Feld E wird teilweise von der zweiten Elektrode 4 aufgenommen und auf diese Weise ein Verschiebestrom induziert, der entsprechend gemessen werden kann. Dabei wirken sich auf das elektrische Feld auch etwa Objekte aus, welche in einem Bereich zwischen Elektroden 2 oder 4 sind, jedoch auch solche, die in einem entfernten Bereich zwischen den beiden Elektroden 2 und 4 befindlich sind.

Allerdings wirken sich auf die Messung auch Störungen bzw. Objekte aus, wie etwa Wasserfilme, Verschmutzungen oder dergleichen.

Figur 2 zeigt grob schematisch eine erfindungsgemäße Sensoreinrichtung 1. Auch diese weist wieder eine erste Elektrode 2 auf, sowie eine zweite Elektrode 4. Die erste Elektrode 2 wird dabei über eine Signalerzeugungseinrichtung 22 mit einem Signal S1 beaufschlagt und erzeugt auf diese Weise ein elektrisches Feld E1. Dieses elektrische Feld E1 wird von der zweiten Elektrode 4 aufgenommen, welche einen Verschiebestrom V1 erzeugt, der wiederum mittels einer Messeinrichtung gemessen werden kann.

Entsprechend kann der Verschiebestrom oder ein zu diesem korrespondierendes Signal über eine Auswerteeinrichtung 10 als erstes Messsignal ausgegeben werden. Die Auswerteeinrichtung 10 berechnet daher vorteilhaft aus dem Verschiebestrom das erste Messsignal M1.

Die beiden Elektroden 2 und 4 sind hier plattenförmig ausgebildet und bevorzugt parallel zueinander, sodass sich die elektrischen Feldlinien nicht nur in gerader Richtung zwischen den Elektroden 2, 4 erstrecken, sondern den in Figur 2 gezeigten gekrümmten Verlauf annehmen. Auf diese Weise können auch Objekte im Fernbereich der beiden Elektroden 2, 4 registriert werden, obwohl dieser Fernbereich nicht geometrisch zwischen den Elektroden 2, 4 angeordnet ist bzw. liegt.

Bevorzugt sind die genannten Elektroden auf einem gemeinsamen Träger angeordnet. Weiterhin können auch die Signalerzeugungseinrichtung(en) auf diesem Träger angeordnet sein.

Das Bezugszeichen 6 kennzeichnet eine dritte Elektrode, die hier im Bereich der zweiten Elektrode 4 angeordnet ist. Bei dem in Figur 2 gezeigten Zustand wird diese dritte Elektrode 6 nicht mit einem Signal versorgt. Allerdings ist auch hier eine Signalerzeugungseinrichtung 62 vorgesehen, welche die dritte Elektrode 6 mit einem insbesondere elektrischen Signal beaufschlagen kann.

Das Bezugszeichen 8 kennzeichnet eine Steuerungseinrichtung, welche die Ansteuerung der ersten Elektrode 2 sowie der dritten Elektrode 6 mit einem Signal bewirkt. Diese Steuerungseinrichtung kann dabei diese beiden Signalerzeugungseinrichtungen 22 und 62 beispielsweise zu unterschiedlichen Zeiträumen ansteuern. Es wird jedoch darauf hingewiesen, dass die Steuerungseinrichtung 8 sowie die beiden Signalerzeugungseinrichtungen 22 und 62 auch in einer gemeinsamen Steuerungseinheit untergebracht sein können.

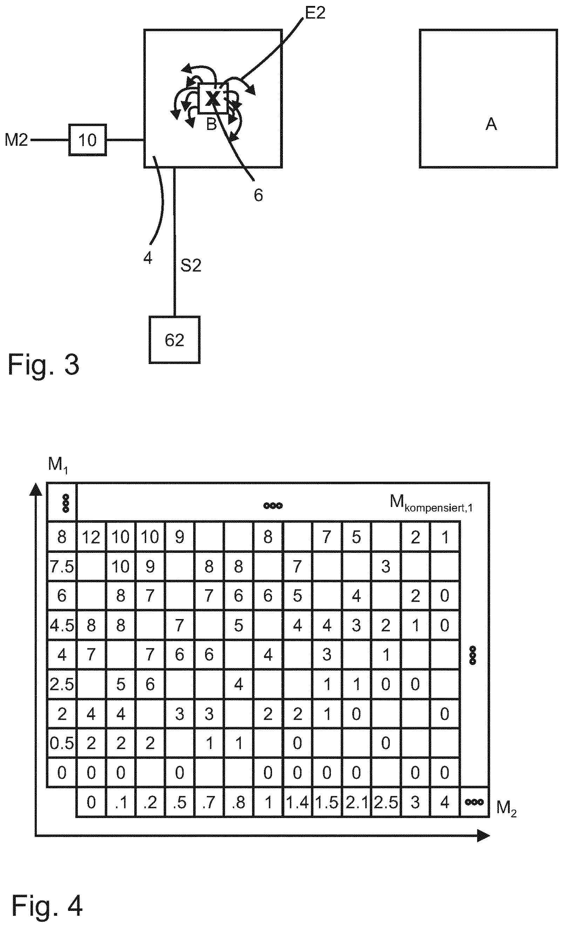

Figur 3 zeigt eine Darstellung der in Figur 2 gezeigten Sensoreinrichtung 1. Bei der in Figur 3 gezeigten Situation wird nicht mehr die erste Elektrode 2 mit einem Signal beaufschlagt, sondern die dritte Elektrode 6. Diese gibt ebenfalls ein elektrisches Feld E2 ab, jedoch nur bzw. insbesondere im Nahbereich, sodass dieses elektrische Feld hier ebenfalls nur von der zweiten Elektrode 4 registriert wird. Auf dieses elektrische Feld E2 wirken sich insbesondere auch Störungen im Nahbereich der zweiten Elektrode 4 aus. Die Messsignale der dritten Elektrode 6 bzw. die von dieser ausgegebenen Signale können verwendet werden, um Störungen im Nahbereich der Sensoreinrichtung zu erfassen bzw. Werte entsprechend zu kalibrieren.

In Reaktion auf dieses Feld E2 kann wiederum ein Verschiebestrom an die Auswerteeinrichtung 10 ausgegeben werden, welche hieraus ein zweites Messsignal M2 berechnet. Weiterhin kann die Auswerteeinrichtung oder aber eine Prozessoreinrichtung (nicht gezeigt) aus dem ersten Messsignal M1 und dem zweiten Messsignal M2 ein kompensiertes Signal Mₖₒₘₚₑₙₛᵢₑᵣₜ ermitteln.

Figur 4 zeigt ein Beispiel für eine zweidimensionale Nachschlagtabelle (look up table). Dabei sind auf der Ordinate die Messwerte M1 aufgetragen und auf der Abszissedie Messwerte M2. Die Zellen beinhalten die einzelnen kompensierten Messwerte Mₖₒₘₚₑₙₛᵢₑᵣₜ. Unter Verwendung dieser LUT (look up table) können bei Auftreten unterschiedlicher Messwerte M2 und M1 jeweils kompensierte Messwerte ermittelt werden oder aber etwa durch Interpolation bzw. Mittelwertbildung ermittelt werden.

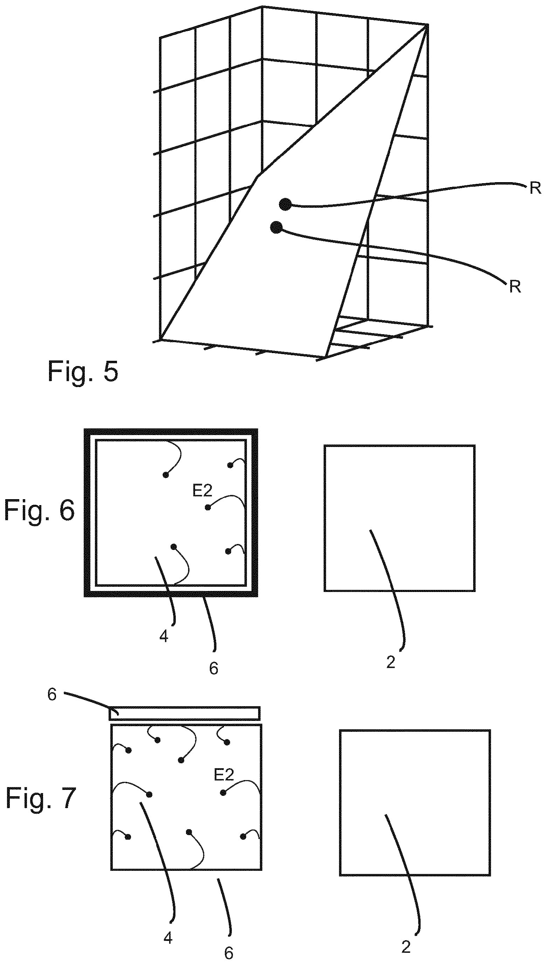

Figur 5 zeigt eine grafische Darstellung im Rahmen eines weiteren Messverfahrens. Hier wird eine quadratische Modellfunktion dargestellt, welche auf eine zweidimensionale Wertetabelle aufgetragen ist. Die Randbedingungen sind dabei durch die Bezugszeichen R gekennzeichnet. Wie oben erwähnt, können jedoch auch weitere Stützpunkte aus einer Kalibration zur Hilfe genommen werden, um Modellparameter festzulegen.

Neben der in Figur 2 gezeigten Anordnung der weiteren Elektrode sind auch weitere Anordnungen der Elektroden denkbar.

So zeigt beispielsweise Figur 6 ein Beispiel, bei dem die dritte Elektrode 6 die zweite Elektrode bzw. Messelektrode umschließt. Figur 7 zeigt eine Ausgestaltung, bei der die dritte Elektrode seitlich neben der zweiten Elektrode bzw. Messelektrode angeordnet ist. Allen diesen Anordnungen ist jedoch gemeinsam, dass die dritte Elektrode im Vergleich zu der Sendeelektrode bzw. der ersten Elektrode 1 eine kleine Fläche einnimmt und einen geringeren Abstand zur Messelektrode 4 aufweist.

Außerdem ist es für die Kompensierbarkeit von Wassertropfen, abfließendem Wasser und mechanischen Veränderungen im Nahbereich der Sensoreinrichtung bei allen Anordnungen vorteilhaft, wenn die dritte Elektrode bzw. Kompensationselektrode in Richtung desjenigen Raumbereichs frei wirken kann, in dem das elektrische Feld zwischen der Sendeelektrode und der Messelektrode besteht. Die Bezugszeichen E2 kennzeichnen jeweils die Feldlinien bei der Messung der von der dritten Elektrode ausgegebenen elektrischen Felder. Bei der in Figur 6 und Figur 7 gezeigten Situation ist jeweils die dritte Elektrode aktiviert und damit liegt die Betriebsartkompensation des Umgebungseinflusses mit der dritten Elektrode als aktiver Sendeelektrode vor.

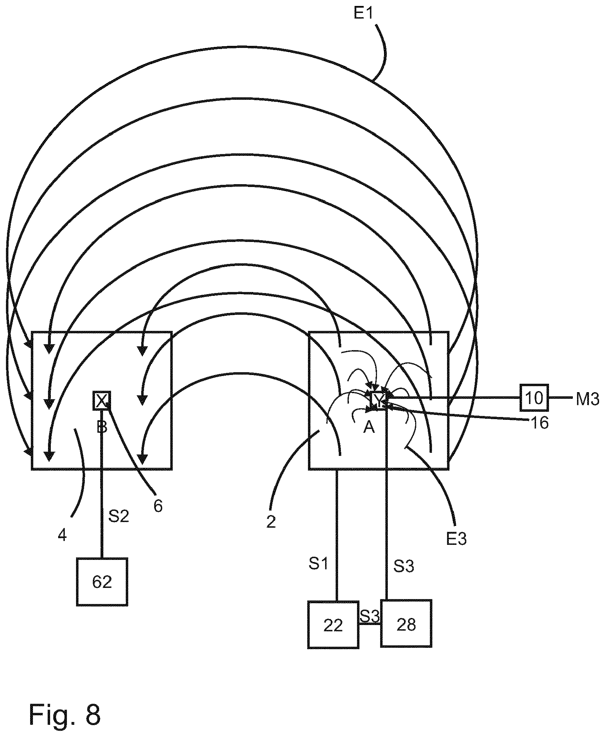

Figur 8 zeigt eine weitere Ausgestaltung einer erfindungsgemäßen Sensoreinrichtung. Bei dieser Ausgestaltung weist die Sensoreinrichtung zwei Kompensationselektroden auf. Die Sensoreinrichtung mit der einen Kompensationselektrode 6 ist hier um eine zweite Kompensationselektrode 16 bzw. eine vierte Elektrode 16 erweitert. Diese Elektrode ist nahe der ersten Elektrode 2, beispielsweise hier innerhalb der ersten Elektrode 2, platziert.

Diese Elektrode 16 wird bevorzugt als zweite Messelektrode beschaltet und nimmt bevorzugt einen Messwert M3 in der Betriebsart "Elektrode 2 angesteuert" auf. Die vierte Elektrode 16 ist dabei derart gestaltet und angeordnet, dass sich das Feld zwischen der ersten Elektrode bzw. Sendeelektrode 2 und der vierten Elektrode 16 räumlich auf den Nahbereich der Sendeelektrode, das heißt der ersten Elektrode 2 konzentriert.

Neben der in Figur 8 gezeigten Ausgestaltung wären auch andere Ausgestaltungen möglich, insbesondere beispielsweise Kombinationen mit den in Figur 6 und 7 gezeigten Ausgestaltungen.

Bevorzugt sind also bei der in Figur 8 gezeigten Ausgestaltung neben der ersten und der zweiten Elektrode zwei weitere Elektroden bzw. Kompensationselektroden 6, 16 vorgesehen, welche auf diese Weise eine Nahbereicherkennung, sowohl im Bereich der ersten Elektrode als auch im Bereich der zweiten Elektrode ermöglichen.

Die Anmelderin behält sich vor, sämtliche in den Anmeldungsunterlagen offenbarten Merkmale als erfindungswesentlich zu beanspruchen, sofern sie einzeln oder in Kombination gegenüber dem Stand der Technik neu sind. Es wird weiterhin darauf hingewiesen, dass in den einzelnen Figuren auch Merkmale beschrieben wurden, welche für sich genommen vorteilhaft sein können. Der Fachmann erkennt unmittelbar, dass ein bestimmtes in einer Figur beschriebenes Merkmal auch ohne die Übernahme weiterer Merkmale aus dieser Figur vorteilhaft sein kann. Ferner erkennt der Fachmann, dass sich auch Vorteile durch eine Kombination mehrerer in einzelnen oder in unterschiedlichen Figuren gezeigter Merkmale ergeben können.

### Bezugszeichenliste

- 1: Sensoreinrichtung
- 2: erste Elektrode
- 4: zweite Elektrode
- 6: dritte Elektrode
- 8: Steuerungseinrichtung
- 10: Auswerteeinrichtung
- 15: Träger
- 16: Kompensationselektrode, vierte Elektrode
- 18, 22, 62: Signalerzeugungseinrichtung
- 100: Sensoreinrichtung (Stand der Technik)
- E, E1, E2: elektrisches Feld
- M1, M2, M3: Messwerte
- Mₖₒₘₚₑₙₛᵢₑᵣₜ: kompensierter Messwert
- E: Feldlinien
- R: Randbedingungen
- S, S1, S2, S3: (elektrisches) Signal
- V1: Verschiebestrom

## Patentansprüche

1. Sensoreinrichtung (1) mit einer ersten Elektrode (2), mit einer Signalerzeugungseinrichtung (22), welche diese erste Elektrode (2) mit einem elektrischen Signal (S) beaufschlagt, wodurch die erste Elektrode (2) ein elektrisches Feld (E1) ausgibt, mit einer zweiten Elektrode (4), welche von der ersten Elektrode (2) beabstandet ist, zur Aufnahme des von der ersten Elektrode ausgegebenen elektrischen Feldes,
**dadurch gekennzeichnet, dass**
die Sensoreinrichtung (1) eine dritte Elektrode (6) aufweist, sowie eine Signalerzeugungseinrichtung (62), welche diese weitere Elektrode (6) mit einem zweiten elektrischen Signal (S2) beaufschlagt, wodurch die weitere Elektrode (6) ein weiteres elektrisches Feld (E2) ausgibt.

2. Sensoreinrichtung (1) nach Anspruch 1,
**dadurch gekennzeichnet, dass**
die erste und/oder die zweite Elektrode (4) dazu geeignet und bestimmt ist, das von der dritten Elektrode (6) ausgegebene elektrische Feld (E2) aufzunehmen.

3. Sensoreinrichtung (1) nach wenigstens einem der vorangegangenen Ansprüche,
**dadurch gekennzeichnet, dass**
die Sensoreinrichtung (1) eine Steuerungseinrichtung (8) aufweist, welche bewirkt, dass zu ersten vorgegebenen Zeiträumen die erste Elektrode (2) mit dem ersten Signal (S1) beaufschlagt wird und zu zweiten vorgegebenen Zeiträumen die dritte Elektrode (6) mit dem zweiten Signal (S2) beaufschlagt wird.

4. Sensoreinrichtung (1) nach wenigstens einem der vorangegangenen Ansprüche,
**dadurch gekennzeichnet, dass**
die dritte Elektrode (6) näher an der zweiten Elektrode (4) als an der ersten Elektrode (2) angeordnet ist.

5. Sensoreinrichtung (1) nach wenigstens einem der vorangegangenen Ansprüche,
**dadurch gekennzeichnet, dass**
eine Elektrodenfläche der dritten Elektrode (6) kleiner ist als eine Elektrodenfläche der ersten Elektrode (2) und/oder eine Elektrodenfläche der zweiten Elektrode (4).

6. Sensoreinrichtung (1) nach wenigstens einem der vorangegangenen Ansprüche,
**dadurch gekennzeichnet, dass**
die Sensoreinrichtung (1) eine Auswerteeinrichtung (10) aufweist, welche die von der zweiten Elektrode aufgenommenen Signale auswertet.

7. Sensoreinrichtung (1) nach wenigstens einem der vorangegangenen Ansprüche,
**dadurch gekennzeichnet, dass**
die Sensoreinrichtung (1) eine vierte Elektrode (16) aufweist.

8. Verfahren zum Betreiben einer kapazitiven Sensoreinrichtung wobei einer Signalerzeugungseinrichtung (22), eine erste Elektrode (2) mit einem ersten elektrischen Signal (S1) beaufschlagt, wodurch die erste Elektrode (2) ein elektrisches Feld (E1) ausgibt, und wobei mit einer zweiten Elektrode (4), welche von der ersten Elektrode (2) beabstandet ist, das von der ersten Elektrode (2) ausgegebene elektrische Feld (E1) aufgenommen wird,
**dadurch gekennzeichnet, dass**
die Sensoreinrichtung (1) eine dritte Elektrode (6) aufweist, sowie eine Signalerzeugungseinrichtung (62), welche diese dritte Elektrode (6) mit einem zweiten elektrischen Signal (S2) beaufschlagt, wodurch die dritte Elektrode (6) ein weiteres elektrisches Feld (E2) ausgibt.

9. Verfahren nach dem vorangegangenen Anspruch,
**dadurch gekennzeichnet, dass**
zeitweise die erste Elektrode (2) und zeitweise die dritte Elektrode (6) mit einem elektrischen Signal beaufschlagt wird.

10. Verfahren nach wenigstens einem der vorangegangenen Ansprüche.
**dadurch gekennzeichnet, dass**
mittels einer Auswerteeinrichtung ein Messwert (M1) ermittelt wird, der von dem von der ersten Elektrode ausgegebenen und von der zweiten Elektrode (4) aufgenommenen elektrischen Feld abhängt und weiterhin ein zweiter Messwert (M2) ermittelt wird, der von dem von der dritten Elektrode ausgegebenen und von der zweiten Elektrode (4) aufgenommenen elektrischen Feld abhängt und auf Grundlage des ersten Messwerts (M1) sowie des zweiten Messwerts (M2) ein kompensierter Messwert (Mₖₒₘₚₑₙₛᵢₑᵣₜ) ermittelt wird.
